# EUROPÄISCHE PATENTSCHRIFT

(11) **EP 1 410 047 B1**
(45) Veröffentlichungstag und Bekanntmachung des Hinweises auf die Patenterteilung: **28.02.2007**
(21) Anmeldenummer: 01971787.5
(22) Anmeldetag: 26.07.2001
(51) Int. Cl.: G01P 15/125, G01P 15/08, G01P 15/00, G02B 26/10, G02B 26/08, B81B 3/00

(54) **MIKROMECHANISCHES BAUELEMENT**
MICROMECHANICAL COMPONENT
COMPOSANT MICROMECANIQUE

(43) Veröffentlichungstag der Anmeldung: 21.04.2004
(73) Patentinhaber: Fraunhofer-Gesellschaft zur Förderung der angewandten Forschung e.V., 80686 München (DE)
(72) Erfinder: SCHENK, Harald, 01139 Dresden (DE)
(74) Vertreter: Stöckeler, Ferdinand
(86) Internationale Anmeldenummer: PCT/EP2001/008674
(87) Internationale Veröffentlichungsnummer: WO 2003/010545

(56) Entgegenhaltungen:
- US-A- 5 903 383
- US-A- 6 164 134
- US-B1- 6 188 504

## Beschreibung

Die vorliegende Erfindung bezieht sich auf ein mikromechanisches Bauelement mit einer einzigen statischen Elektrode und insbesondere auf einen mikromechanischen Sensor zur Bestimmung einer Kraft, Beschleunigung, oder Winkelbeschleunigung und auf einen mikromechanischen Aktor für die kontinuierliche oder quasistatische Ablenkung von Licht.

Eine Vielzahl mikromechanischer Aktoren und Sensoren beruht auf der Abhängigkeit von elektrostatischen Kapazitäten zwischen statischen Elektroden und einer Elektrode auf einem bewegbaren Bauglied von einem Auslenkungszustand des Baugliedes. Die Abhängigkeit der einen oder mehreren Kapazitäten von dem Auslenkungszustand des Baugliedes kann einerseits in einem Sensor ausgenützt werden, um mittels einer Kapazitätsmessung den Auslenkungszustand des Baugliedes zu erfassen. Andererseits bewirkt die Abhängigkeit einer Kapazität von dem Auslenkungszustand des Baugliedes, daß beim Anlegen einer Spannung an die Kapazität eine auf das bewegbare Bauglied wirkende Kraft seinen Auslenkungszustand beeinflußt. Dies ist die Grundlage mikromechanischer, elektrostatisch betriebener Aktoren.

In vielen Fällen wird zur Erfüllung der Funktionalität eines Aktors bzw. Sensors eine Auslenkung eines über eine oder mehrere Federn bzw. elastische Verbindungselemente bewegbar an einem Substrat angebrachten bzw. aufgehängten Baugliedes benötigt, wobei die Auslenkung des bewegbaren Baugliedes bzw. Körpers zumindest in einem Freiheitsgrad oder einer Dimension möglich sein muß. Dazu werden dem bewegbaren Bauglied gegenüber mehrere unabhängig voneinander elektrisch kontaktierbare Elektroden angeordnet, welche statisch bzw. gegenüber dem Substrat unbewegbar direkt oder indirekt an diesem angebracht sind. Um dieses mikromechanische Bauelement als Aktor zu betreiben, werden eine oder mehrere Spannungen jeweils zwischen einer statischen Elektrode und dem bewegbaren Bauglied bzw. einer Elektrode auf demselben angelegt. Je nach dem, zwischen welcher statischen Elektrode und dem bewegbaren Bauglied eine elektrische Spannung angelegt wird, wird das bewegbare Bauglied in Richtung der jeweiligen statischen Elektrode ausgelenkt.

Um das beschriebene mikromechanische Bauelement als Sensor zu verwenden, werden eine oder mehrere elektrostatische Kapazitäten zwischen jeweils einer statischen Elektrode und dem bewegbaren Bauglied gemessen. Eine Änderung einer Kapazität zwischen einer bestimmten statischen Elektrode und dem bewegbaren Bauglied ermöglicht einen unmittelbaren Rückschluß auf eine Auslenkung des bewegbaren Baugliedes in Richtung auf die statische Elektrode zu oder von ihr weg.

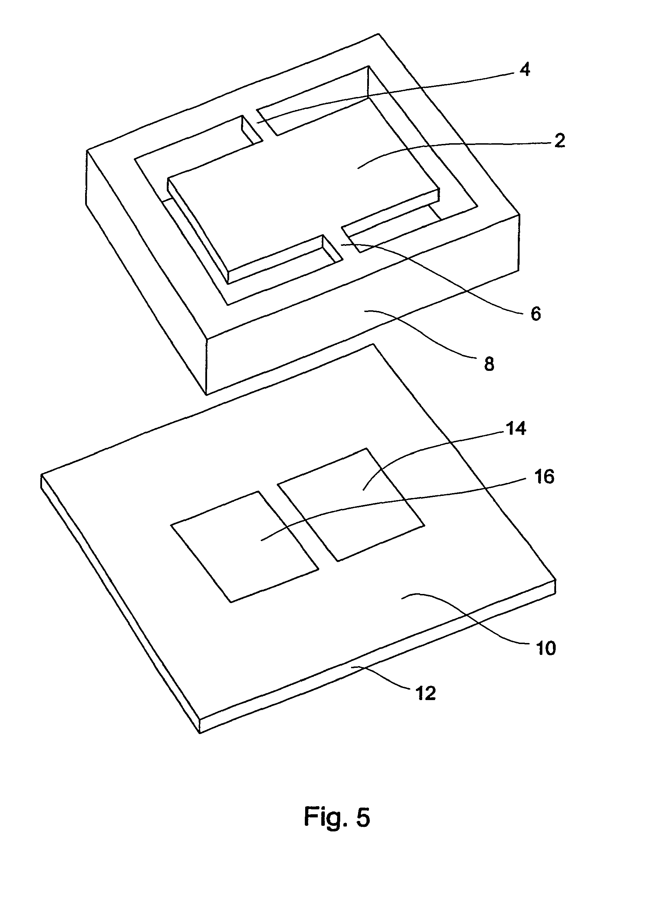

Fig. 5 ist eine schematische, perspektivische Darstellung eines mikromechanischen Bauelements gemäß dem Stand der Technik. Das mikromechanische Bauelement weist ein bewegbares Bauglied 2 auf, welches mittels eines ersten elastischen Verbindungselements 4 und eines zweiten elastischen Verbindungselements 6 an einem Rahmen 8 angebracht ist. Das bewegbare Bauglied 2 ist typischerweise im wesentlichen plattenförmig und einstückig mit den elastischen Verbindungselementen 4, 6 und dem Rahmen 8 oder Teilen des Rahmens 8 ausgeführt. Der Rahmen 8 ist auf einer Oberfläche 10 eines Substrats 12 angebracht. Obwohl das bewegbare Bauglied 2, die elastischen Verbindungselemente 4, 6 und der Rahmen 8 einerseits und das Substrat 12 andererseits in Fig. 5 räumlich getrennt dargestellt sind, um die Oberfläche 10 des Substrats 12 darstellen zu können, ist der Rahmen 8 bei einem funktionstüchtigen mikromechanischen Bauelement des dargestellten Grundtyps an der Oberfläche 10 des Substrats 12 angebracht. Der Rahmen stellt hier lediglich beispielhaft eine Möglichkeit dar, wie die elastischen Verbindungselemente 4,6 mit dem Substrat 12 mechanisch starr verbunden werden können. An der Oberfläche 10 des Substrats 12 sind ferner dem bewegbaren Bauglied 2 gegenüberliegend zwei voneinander und von dem bewegbaren Bauglied 2 elektrisch isolierte Elektroden 14, 16 angeordnet.

Das bewegbare Bauglied 2 und die elastischen Verbindungselemente 4, 6 weisen elektrisch leitfähige Materialien auf oder sind an einer Oberfläche mit einer zusammenhängenden elektrisch leitfähigen Schicht versehen. Das Substrat 12 weist typischerweise ein elektrisch isolierendes Material auf, wobei die Elektroden 14, 16 Metallschichten auf der Oberfläche 10 des Substrats 12 sind, oder das Substrat 12 weist ein Halbleitermaterial auf, welches in den Bereichen der Elektroden 14, 16 dotiert und somit elektrisch leitfähig und außerhalb der Bereiche der Elektroden 14, 16 undotiert und somit elektrisch isolierend ist.

Das bewegbare Bauglied 2 weist eine durch die elastischen Verbindungselemente 4, 6 definierte Ruhelage auf, in der es im vorliegenden Beispiel parallel zur Oberfläche 10 des Substrats 12 ausgerichtet ist. Das bewegbare Bauglied 2 kann durch eine äußere Kraft oder durch eine Winkelbeschleunigung aus dieser Ruhelage ausgelenkt werden, wobei diese Auslenkung um so größer ist, je stärker die Kraft bzw. größer die Beschleunigung ist.

Eine erste elektrostatische Kapazität zwischen der ersten Elektrode 14 und dem bewegbaren Bauglied 2 und eine zweite elektrostatische Kapazität zwischen der zweiten Elektrode 16 und dem bewegbaren Bauglied 2 sind von dem Auslenkungszustand des bewegbaren Baugliedes 2 abhängig. Wenn das bewegbare Bauglied 2 bezogen auf die Darstellung in Fig. 5 nach links kippt, nähert es sich der zweiten Elektrode 16 und entfernt sich von der ersten Elektrode 14, wodurch die erste Kapazität zwischen der ersten Elektrode 14 und dem bewegbaren Bauglied 2 abnimmt und die zweite Kapazität zwischen der zweiten Elektrode 16 und dem bewegbaren Bauglied 2 zunimmt. Wenn umgekehrt das bewegbare Bauglied 2 bezogen auf die Darstellung in Fig. 5 nach rechts kippt erhöht sich die erste Kapazität und verringert sich die zweite Kapazität.

Abgesehen von einer Optimierung des in Fig. 5 im Prinzip dargestellten mikromechanischen Bauelementes für eine konkrete Aufgabenstellung bzw. Anwendung ist es sowohl als Sensor als auch als Aktor betreibbar. Wenn das mikromechanische Bauelement als Sensor betrieben wird, ist das bewegbare Bauglied 2 vorzugsweise asymmetrisch aufgehängt, und durch eine nicht dargestellte elektronische Auswerteeinrichtung werden die erste Kapazität und die zweite Kapazität gemessen und aus ihren Meßwerten der Auslenkungszustand des bewegbaren Baugliedes 2 bestimmt. Daraus wiederum kann bei bekannter Elastizität der Verbindungselemente 4, 6 die einwirkende Kraft oder Beschleunigung bestimmt werden.

Wenn das mikromechanische Bauelement als Aktor betrieben wird, werden durch eine nicht dargestellte Einrichtung eine erste Spannung zwischen der ersten Elektrode 14 und dem bewegbaren Bauglied 2 und eine zweite Spannung zwischen der zweiten Elektrode 16 und dem bewegbaren Bauglied 2 angelegt. Diese elektrischen Spannungen erzeugen Kräfte, welche auf die der jeweiligen Elektrode 14, 16 gegenüberliegenden Bereiche des bewegbaren Baugliedes 2 wirken und insgesamt eine Auslenkung des bewegbaren Baugliedes 2 aus seiner Ruhelage zur Folge haben. Wenn beispielsweise die von dem Substrat 12 abgewandte Oberfläche des bewegbaren Baugliedes 2 eben und lichtreflektierend ausgeführt ist, kann eine durch die beiden elektrischen Spannungen hervorgerufene Auslenkung des bewegbaren Baugliedes 2 dazu verwendet werden, Licht, beispielsweise einen Laserstrahl, unter einem erwünschten, durch Wahl der ersten und der zweiten Spannung einstellbaren Winkel zu reflektieren.

Zur Herstellung eines mikromechanischen Bauelements, wie es in Fig. 5 schematisch dargestellt ist, sind im wesentlichen zwei Verfahren geeignet, die im folgenden dargestellt werden.

Beim hybriden Aufbau werden die erste Elektrode 14 und die zweite Elektrode 16 als statische Gegenelektroden zum bewegbaren Bauglied 2 getrennt von diesem, d. h. auf einem zweiten Werkstück bzw. Wafer gefertigt. In dem Artikel "E-lectrostatically actuated micromirror devices in silicon technology" von W. Lang et al. (Sensors and Actuators 74 (1999) 216-218) wird ein Bauelement zur Ablenkung von Licht beschrieben, bei dem zwei statische und voneinander unabhängig ansteuerbare Gegenelektroden auf einem ersten Wafer gefertigt werden. Dieser wird durch anodisches Bonden mit einer Pyrexplatte verbunden. Ein über Federn bzw. elastische Verbindungselemente aufgehängtes bewegbares Bauglied wird in einem zweiten Wafer gefertigt. Anschließend wird der zweite Wafer ebenfalls durch anodisches Bonden mit der Pyrexplatte so verbunden, daß das bewegbare Bauglied den beiden statischen Gegenelektroden gegenüber liegt. Ein entsprechender Aufbau wird auch in dem Artikel "Electrostatically driven micromirrors for a miniaturized confocal laser scanning microscope" von U. Hofmann et al. (Teil der "SPIE Conference on Miniaturized Systems with Micro-Optics and MEMS", Santa Clara, September 1999, SPIE Band 3878, S. 29-38) beschrieben.

In dem Artikel "Laser Display Technology" von J. Kränert et al. ("The eleventh Annual International Workshop on Micro Electro Mechanical Systems", 25. bis 29. Januar 1998, Heidelberg, IEEE Katalog Nr. 98CH36176, S. 99-103) wird ein Mikrospiegel-Array beschrieben, welches einen Glaswafer und einen Siliziumwafer aufweist. In den Glaswafer werden Hohlräume geätzt, in die Elektroden eingebracht werden, um einen Abstand zwischen den Elektroden und Spiegelplatten zu erhalten. Durch Naßätzen und chemisch-mechanisches Polieren werden 15 µm dicke Membranen gefertigt. Die Spiegelform wird durch Plasmaätzen hergestellt. Der Siliziumwafer und der Glaswafer werden durch anodisches Bonden verbunden. Dabei liegen sowohl bei diesem als auch bei einem weiteren beschriebenen Verfahren einem Mikrospiegel jeweils zwei statische Elektroden gegenüber.

Die US 5,097,354 beschreibt einen Strahl-Abtaster bzw. Strahl-Scanner mit einem lichtemittierenden Element und einem bewegbaren, reflektierenden Spiegel. An der Oberflächeeiner Elektrodenbasis sind vier statische Elektroden gebildet. Den vier coplanaren Elektroden gegenüberliegend ist der Spiegel über Torsionsbalken mit einer Spiegelbasis verbunden, welche mittels Stiften starr an der Elektrodenbasis befestigt ist.

Die US 4,317,611 beschreibt eine Lichtstrahlablenkungsvorrichtung vom Torsionstyp welche zwei geätzte Platten aufweist. Eine der beiden weist ein monokristallines Halbleitermaterial, wie z. B. Silizium, auf, die andere Platte weist ein geeignetes isolierendes Material, wie z. B. Glas, auf. Die Halbleiterplatte ist geätzt, um einen länglichen Balken mit einem breiteren mittleren Abschnitt, welcher eine reflektierende Oberfläche aufweist, zu bilden. In der Mitte der isolierenden Platte ist eine Vertiefung geätzt, wobei ein länglicher Steg in der Mitte der isolierenden Platte unter dem Bereich mit der reflektierenden Oberfläche und den Torsionsbalken zu liegen kommt um diese in Richtung senkrecht zu ihrer Längsachse zu stützen, wobei ihre Rotation um die Längsachse ermöglicht wird. In der Vertiefung in der isolierenden Platte liegen ebene Elektroden, die dafür vorgesehen sind, eine elektrostatische Kraft zwischen einer der ebenen Elektroden und der Halbleitervorrichtung auszuüben und damit eine Winkelauslenkung um die Längsachse der Torsionsbalken zu bewirken.

Die US 5,629,790 beschreibt mikrobearbeitete Torsionsscanner bei denen in verschiedenen vorgeschlagenen Geometrien jeweils zwei Elektroden einem von Torsionsbalken gehaltenen Spiegel gegenüber liegen. Ein Siliziumbauglied mit dem Spiegel und ein dielektrisches Substrat mit den beiden Elektroden werden getrennt gefertigt.

Ein Vorteil des hybriden Aufbaus ist, daß er keine inhärente Beschränkung des Abstandes zwischen dem bewegbaren Bauglied und den statischen Gegenelektroden aufweist, so daß auch große Abstände möglich sind und folglich große Auslenkungen des bewegbaren Baugliedes generiert bzw. detektiert werden können.

Ein Nachteil des hybriden Aufbaus ist der aufwendige Herstellungsprozeß, der auf der Verwendung und Bearbeitung mehrerer Wafer beruht. Da die auf einem Wafer gefertigten statischen Gegenelektroden bezüglich des auf einem anderen Wafer gefertigten bewegbaren Baugliedes und gegenüber den elastischen Verbindungselementen mit hoher Genauigkeit lateral ausgerichtet sein müssen, müssen die beiden Wafer vor einem Bondungsprozeß mit eben dieser hohen Genauigkeit ausgerichtet werden, woraus ein erheblicher fertigungstechnischer Aufwand resultiert. Darüber hinaus gestaltet sich die Aufbau- und Verbindungstechnik aufwendig, da die statischen Gegenelektroden und das bewegbare Bauglied nicht coplanar angeordnet sind und somit auch ihre elektrische Kontaktierung zunächst in zwei verschiedenen Ebenen erforderlich ist. Auch eine Kontaktierung der statischen Gegenelektroden über das Substrat bzw. die Bauelementrückseite ist nicht ohne weiteres möglich, da zwei voneinander elektrisch unabhängige Elektroden kontaktiert werden müssen.

Beim integrierten Aufbau werden mit Hilfe einer sogenannten Opferschicht das über elastische Verbindungselemente bewegbar aufgehängte Bauglied und die statischen Gegenelektroden auf ein und demselben Substrat hergestellt. Dazu werden zunächst die statischen Gegenelektroden auf dem Substrat gefertigt. Dann wird die Opferschicht auf das die statischen Gegenelektroden enthaltende Substrat aufgebracht. Auf der Opferschicht wird eine Schicht eines elektrisch leitfähigen Materials aufgebracht und in der gewünschten Form des bewegbaren Baugliedes und der elastischen Verbindungselemente strukturiert. Anschließend wird die Opferschicht entfernt, und somit das bewegbare Bauglied und die elastischen Verbindungselemente freigelegt.

Der Artikel "Novel beam steering micromirror device" von R.W. Fuchs et al. (Teil der "SPIE Conference on Miniaturized Systems with Micro-Optics and MEMS", Santa Clara, September 1999, SPIE Band 3878, S. 40-49) beschreibt ein Mikrospiegelbauelement zur Lichtmodulation, bei dem eine elektrisch leitfähige Spiegelplatte im wesentlichen parallel zu einem Substrat mit mehreren statischen Elektroden angeordnet und über eine zwischen der Spiegelplatte und dem Substrat lateral mittig angeordnete elastische Gelenkstruktur mit dem Substrat verbunden ist. Die statischen Elektroden, die elastische Gelenkstruktur und die Spiegelplatte werden nacheinander direkt auf dem Substrat und unter Verwendung einer Opferschicht hergestellt, die anschließend entfernt wird.

Der Artikel "Design and fabrication of micromirror array with hidden joint structures" von C.-H. Ji und Y-K. Kim (Teil der "SPIE Conference on Miniaturized Systems with Micro-Optics and MEMS", Santa Clara, September 1999, SPIE Band 3878, S. 71-77) beschreibt den Entwurf und die Herstellung eines Arrays von Mikrospiegeln mit mikrobearbeiteten Oberflächen. Eine Spiegelplatte ist im wesentlichen parallel zu einem Substrat mit mehreren Elektroden angeordnet und von diesen beabstandet. Spiegelplatte und Substrat sind durch eine mittig zwischen den beiden angeordnete Verbindungsstruktur bewegbar miteinander verbunden, wobei die Verbindungsstruktur einen Stift und Klammern aufweist, und wobei eine Bewegung der Spiegelplatte um eine durch den Stift definierte Achse möglich ist.

Der Artikel "Micromirrors for direct writing systems and scanners" von H. Lakner et al. (Teil der "SPIE Conference on Miniaturized Systems with Micro-Optics and MEMS" , Santa Clara, September 1999, SPIE Band 3878, S. 217-227) beschreibt Ausleger-Strahlmikrospiegel, welche freistehende Spiegelelemente umfassen, die durch Tragepfosten über einen Luftspalt und einer darunterliegenden Adreßelektrode gehalten werden.

Beim integrierten Aufbau wird die Opferschicht entweder naßchemisch oder mittels eines reaktiven Gases entfernt. Bei Abmessungen des bewegbaren Baugliedes von mehr als einigen µm sind zusätzliche Öffnungen in dem bewegbaren Bauglied erforderlich, um das Entfernen der Opferschicht zu ermöglichen. Diese Öffnungen verringern die optische Qualität der Oberfläche des bewegbaren Baugliedes, was deren Einsatzmöglichkeiten als elektrostatisch steuerbarer Spiegel in optischen Anwendungen einschränkt. Auch die Dicke der Opferschicht ist aus Gründen der Planität und der Herstellung von Pfosten, welche die mechanische Verbindung der elastischen Verbindungselemente mit dem Substrat darstellen, auf wenige µm beschränkt. Damit wird die maximale Auslenkung des bewegbaren Baugliedes eingeschränkt. Für einige Anwendungen ist es jedoch entscheidend eine große Änderung der elektrischen Kapazität zwischen jeweils einer statischen Elektrode und dem bewegbaren Bauglied zur Erzeugung bzw. Erfassung einer Auslenkung des bewegbaren Baugliedes und gleichzeitig eine große maximale Auslenkung des bewegbaren Baugliedes zu ermöglichen. Diese Erfordernis besteht beispielsweise bei elektrostatisch angetriebenen Scannern. Da die Dicke der Opferschicht jedoch auf wenige µm beschränkt ist, ist der Auslenkwinkel im Fall eines bewegbaren Baugliedes mit großen Abmessungen, d. h. Abmessungen im Bereich von mehreren µm, so gering, daß ein Einsatz solcher Bauelemente sehr stark eingeschränkt ist.

Beispielsweise bei einem in dem oben erwähnten Artikel "Novel beam steering micromirror device" beschriebenen bewegbaren Bauglied mit Abmessungen von 300 µm x 300 µm ist aufgrund der Beschränkung der Dicke der Opferschicht auf wenige µm ein Auslenkwinkel von lediglich zwei Grad erreichbar. Das Einsatzgebiet des Bauelementes ist damit stark eingeschränkt. Entsprechendes gilt für das von Ji und Kim beschriebene Bauelement. Die von Lakner et al. beschriebenen mikromechanischen Bauelemente weisen entweder nur ein einziges Paar einander gegenüberliegende Elektrode auf, weshalb das bewegbare Bauglied aus der Ruhelage nur in eine Richtung ausgelenkt werden kann, oder weisen lediglich Elektroden auf, welche das bewegbare Bauglied in die Ruhelage treiben und sind deshalb nur als Aktor verwendbar, welcher mit seiner Eigenfrequenz oszilliert. Dabei wird bei der Herstellung des von Lakner et al. beschriebenen Bauelements keine Opferschicht verwendet.

Die US 6,188,504 B1 beschreibt einen optischen Scanner mit einem Träger-Bauglied zur Befestigung auf einem gegebenen Bauglied, einer bewegbaren Platte mit einer reflektierenden Oberfläche zum Reflektieren von Licht und ein elastisches Bauglied, das die bewegbare Platte und das Träger-Bauglied miteinander koppelt. Das elastische Bauglied weist eine Mehrzahl von laminierten organischen elastischen isolierenden Schichten auf. Ein Aktuator ist zumindest auf der bewegbaren Platte zum Erzeugen einer Antriebskraft zwischen der bewegbaren Platte und dem Träger-Bauglied vorgesehen. Ein elektrisches Element ist vorgesehen, um ein vorbestimmtes elektrisches Signal an den Aktuator anzulegen und damit die Antriebskraft zu erzeugen, wodurch das elastische. Bauglied elastisch verformt und die bewegbare Platte ausgelenkt wird. Das elektrische Element ist zwischen den organischen elastischen isolierenden Schichten des elastischen Baugliedes vorgesehen. Gemäß einem Ausführungsbeispiel ist der Aktuator ein elektrostatischer Aktuator, wobei zwei bewegbare Elektroden an der Oberfläche der bewegbaren Platte und eine stationäre Elektrode an einem feststehenden Bauglied vorgesehen sind.

Die Aufgabe der Erfindung wird durch ein mikromechanisches Bauelement gemäß Anspruch 1, durch einen Sensor gemäß Anspruch 15 und durch einen Aktor gemäß Anspruch 16 gelöst.

Ein mikromechanisches Bauelement gemäß der vorliegenden Erfindung umfaßt ein Substrat und ein Bauglied, das bewegbar an dem Substrat angebracht ist, wobei das bewegbare Bauglied eine erste Elektrode und eine von der ersten Elektrode elektrisch isolierte zweite Elektrode aufweist, und wobei das Substrat eine dritte Elektrode aufweist, die der ersten Elektrode und der zweiten Elektrode zumindest teilweise gegenüberliegt.

Vorzugsweise ist das bewegbare Bauglied plattenförmig und weist eine erste Oberfläche und eine zweite Oberfläche auf, wobei die erste Elektrode und die zweite Elektrode jeweils mindestens eine Teilfläche der ersten Oberfläche oder eine Teilfläche der zweiten Oberfläche einnehmen.

Gemäß einem bevorzugten Ausführungsbeispiel weist das mikromechanische Bauelement ferner ein erstes und ein zweites torsionselastisches oder biegeelastisches Verbindungselement auf, welche jeweils das bewegbare Bauglied mit dem Substrat verbinden. Das bewegbare Bauglied und die Verbindungselemente können das gleiche Material aufweisen.

Gemäß einem weiteren bevorzugten Ausführungsbeispiel der vorliegenden Erfindung umfaßt das mikromechanische Bauelement ferner einen Rahmen, ein erstes und ein zweites elastisches Verbindungselement, über die das bewegbare Bauglied an zwei gegenüberliegenden Seiten um eine erste Achse drehbewegbar mit dem Rahmen verbunden ist, und ein drittes und ein viertes elastisches Verbindungselement, über die der Rahmen an zwei gegenüberliegenden Seiten um eine zweite Achse drehbewegbar mit dem Substrat verbunden ist, wobei die erste Achse und die zweite Achse im wesentlichen senkrecht zueinander sind und wobei das bewegbare Bauglied ferner eine dritte Elektrode und eine vierte Elektrode aufweist. Das bewegbare Bauglied, die elastischen Verbindungselemente und der Rahmen können dasselbe Material aufweisen.

Bei einem der beschriebenen mikromechanischen Bauelemente gemäß der vorliegenden Erfindung kann das bewegbare Bauglied im wesentlichen aus einem elektrisch leitfähigen Material bestehen, wobei ein erster Bereich des bewegbaren Baugliedes die erste Elektrode bildet, ein zweiter Bereich des bewegbaren Baugliedes die zweite Elektrode bildet, und die erste Elektrode und die zweite Elektrode durch einen elektrisch isolierenden dritten Bereich mechanisch starr miteinander verbunden und elektrisch voneinander isoliert sind. Das Material des bewegbaren Baugliedes kann ein Halbleitermaterial sein, das in den die erste Elektrode und die zweite Elektrode bildenden Bereichen dotiert und elektrisch leitfähig ist, und das in dem elektrisch isolierenden dritten Bereich undotiert ist. Alternativ kann der elektrisch isolierende dritte Bereich einen mit einem elektrisch isolierenden Material aufgefüllten Graben aufweisen. Sofern das bewegbare Bauglied und die Verbindungselemente das gleiche Material aufweisen kann das erste Verbindungselement die erste Elektrode elektrisch leitfähig mit einem ersten elektrischen Leiter verbinden und das zweite Verbindungselement die zweite Elektrode elektrisch leitfähig mit einem zweiten elektrischen Leiter verbinden, so daß über den ersten elektrischen Leiter und das erste Verbindungselement ein erstes elektrische Potential an die erste Elektrode angelegt werden kann und über den zweiten elektrischen Leiter und das zweite Verbindungselement ein zweites, von dem ersten elektrischen Potential unabhängiges Potential an die zweite Elektrode angelegt werden kann.

Das Substrat eines mikromechanischen Bauelementes gemäß der vorliegenden Erfindung kann ein beliebiges elektrisch leitfähiges Material aufweisen, wobei das Substrat ferner eine Schicht oder einen Rahmen aus einem elektrisch isolierenden Material aufweisen kann, wobei die erste Elektrode und die zweite Elektrode sowie eine elektrische Verbindung derselben, beispielsweise über die Verbindungselemente und die elektrischen Leiter, durch den Rahmen oder die Schicht von der dritten Elektrode, die durch das elektrisch leitfähige Material des Substrats gebildet wird, elektrisch isoliert ist.

Alternativ kann das Substrat eines mikromechanischen Bauelementes gemäß der vorliegenden Erfindung ein elektrisch isolierendes Material aufweisen, wobei die dritte Elektrode durch eine Metallisierung an einer dem bewegbaren Bauglied gegenüberliegenden Oberfläche des Substrats gebildet wird.

Alternativ kann das Substrat eines mikromechanischen Bauelementes gemäß der vorliegenden Erfindung ein Halbleitermaterial aufweisen, wobei die dritte Elektrode einen dotierten Bereich des Substrats umfaßt.

Das Substrat eines mikromechanischen Bauelementes gemäß der vorliegenden Erfindung kann eine Grundplatte oder eine Wand eines Gehäuses, in oder an dem das mikromechanische Bauelement angebracht ist, bzw. einen elektrisch leitfähigen Abschnitt derselben aufweisen.

Ein mikromechanisches Bauelement gemäß der vorliegenden Erfindung kann ferner eine weitere Elektrode aufweisen, die bezogen auf das Substrat unbewegbar angeordnet ist, und die bezogen auf das bewegbare Bauglied symmetrisch zu der dritten Elektrode angeordnet ist.

In einem mikromechanischen Bauelement gemäß der vorliegenden Erfindung kann das bewegbare Bauglied mittels eines oder mehrerer elastischer Verbindungselemente oder eines geeigneten Gelenkes so an dem Substrat bewegbar angebracht sein, daß es gegenüber diesem um eine oder mehrere Achsen kippbar oder rotierbar und/oder entlang einer oder mehrere weiterer Achsen translatierbar bzw. verschiebbar ist.

Mehrere mikromechanische Bauelemente gemäß der vorliegenden Erfindung können in einem linearen bzw. eindimensionalen oder in einem zweidimensionalen Array angeordnet sein, wobei die bewegbaren Bauglieder der einzelnen mikromechanischen Bauelemente parallel angesteuert und synchron ausgelenkt oder aber einzeln und voneinander unabhängig bzw. asynchron angesteuert und ausgelenkt werden können.

Ein mikromechanisches Bauelement gemäß der vorliegenden Erfindung kann als Bestandteil eines Sensors vorgesehen sein, bei dem das bewegbare Bauglied durch eine äußere Kraft, Beschleunigung oder Winkelbeschleunigung auslenkbar ist, wobei eine erste elektrostatische Kapazität zwischen der ersten Elektrode und der dritten Elektrode und eine zweite elektrostatische Kapazität zwischen der zweiten Elektrode und der dritten Elektrode von einem Auslenkungszustand des Baugliedes abhängen. Durch eine Messung der ersten Kapazität und der zweiten Kapazität ist je nach der Ausführung des bewegbaren Baugliedes eine Bestimmung der auf ihn wirkenden Kraft, Beschleunigung oder Winkelbeschleunigung möglich. Insbesondere ist beispielsweise ein mikromechanisches Bauelement mit einem bewegbaren Bauglied, das nur um eine Achse durch seinen Schwerpunkt bewegbar aufgehängt ist, dazu geeignet, ausschließlich eine Komponente einer Winkelbeschleunigung in Richtung der Achse, nicht jedoch andere Komponenten einer Winkelbeschleunigung oder eine lineare Beschleunigung zu erfassen. Ein bewegbares Bauglied, das ausschließlich um eine Achse bewegbar aufgehängt ist, die nicht den Schwerpunkt des bewegbaren Baugliedes enthält, ist dazu geeignet eine Beschleunigung in einer Richtung senkrecht zu einer Ebene, die durch die Achse und den Schwerpunkt des bewegbaren Baugliedes definiert wird, zu erfassen.

Ein mikromechanisches Bauelement gemäß der vorliegenden Erfindung kann Bestandteil eines Aktors sein, wobei das bewegbare Bauglied dafür vorgesehen ist, daß zwischen der ersten Elektrode und der dritten Elektrode eine erste Spannung und zwischen der zweiten Elektrode und der dritten Elektrode eine zweite Spannung angelegt werden, wobei ein Auslenkungszustand des Baugliedes von der ersten Spannung und der zweiten Spannung abhängt. Der Aktor kann beispielsweise zur steuerbaren Ablenkung von Licht vorgesehen sein, das an einer lichtreflektierenden Oberfläche des bewegbaren Baugliedes reflektiert wird.

Ein Vorteil der vorliegenden Erfindung besteht darin, daß sie lediglich eine statische Elektrode bzw. Gegenelektrode, nämlich die dritte Elektrode aufweist, deren laterale Ausdehnung beliebig groß sein kann, so daß im Fall eines hybriden Aufbaus des erfindungsgemäßen mikromechanischen Bauelements eine laterale Ausrichtung eines ersten Wafers, der das bewegbare Bauglied umfaßt, und eines zweiten Wafers, der die dritte Elektrode umfaßt, nicht erforderlich ist.

Ein weiterer Vorteil der vorliegenden Erfindung besteht darin, daß die erste und die zweite Elektrode einfach kontaktierbar sind, da sie mit dem bewegbaren Bauglied in der Regel an einer Oberfläche des mikromechanischen Bauelements angeordnet sind. Lediglich eine Elektrode, die dritte Elektrode ist der ersten und der zweiten Elektrode gegenüber in einer anderen Ebene angeordnet. Ihre Kontaktierung ist ebenfalls ohne weiteres und zwar über die Rückseite des mikromechanischen Bauelements oder über ein Gehäuse, das Teil des mikromechanischen Bauelements sein kann, möglich. Dieser Vorteil gewinnt weiter an Bedeutung, wenn ein bewegbares Bauglied mehrere Freiheitsgrade aufweist und dementsprechend zusätzliche Elektroden erforderlich sind, oder wenn mehrere mikromechanische Bauelemente auf einem Wafer ausgeführt sind. In diesem Fall ist es nicht, wie gemäß dem Stand der Technik, erforderlich, eine Mehrzahl von Elektroden voneinander unabhängig elektrisch zu kontaktieren, die in einer anderen Ebene liegen als das bewegbare Bauglied und damit in der Regel nicht ohne weiteres kontaktierbar sind. Vielmehr muß bei einem mikromechanischen Bauelement gemäß der vorliegenden Erfindung auch im Falle mehrerer Freiheitsgrade oder einer Mehrzahl von bewegbaren Baugliedern lediglich eine Elektrode, nämlich die dritte Elektrode, kontaktiert werden, welche in einer anderen Ebene als das oder die bewegbaren Bauglieder liegt. Alle weiteren Elektroden sind an dem oder den bewegbaren Baugliedern angeordnet und somit in der Regel in einer einzigen Ebene an oder nahe einer Oberfläche des mikromechanischen Bauelements.

Durch die Möglichkeit eines Verzichts auf eine präzise Justage oder Ausrichtung und durch die einfache Kontaktierung aller Elektroden wird die Aufbau- und Verbindungstechnik im Vergleich zu herkömmlichen mikromechanischen Bauelementen deutlich vereinfacht.

Anders ausgedrückt wird die Aufgabe der vorliegenden Erfindung dadurch gelöst, daß ein über elastische Verbindungselemente bzw. Federn aufgehängtes bewegbares Bauglied durch isolierende Gräben oder Zwischenräume in mehrere Elektroden unterteilt ist. Jede Elektrode bzw. jeder von anderen Bereichen elektrisch isolierter Bereich des bewegbaren Baugliedes kann über eines oder mehrere elastische Verbindungselemente mit jeweils einem elektrischen Potential verbunden werden. Durch die Aufteilung des bewegbaren Baugliedes in Bereiche mit verschiedenen elektrostatischen Potentialen kann eine einzige Gegenelektrode verwendet werden, die nicht auf einem eigenen Substrat hergestellt werden muß, sondern beispielsweise durch eine Metallplatte oder eine andere leitfähige oder mit einer leitfähigen Schicht versehene Platte gebildet sein kann, auf die ein Chip, der das bewegbare Bauglied und die elastischen Verbindungselemente aufweist, aufgeklebt wird. Anders ausgedrückt weist das Substrat des mikromechanischen Bauelements die Metallplatte oder die andere leitfähige oder mit einer leitfähigen Schicht versehene Platte auf. Dabei kann die leitfähige Platte wiederum Bestandteil eines Gehäuses des mikromechanischen Bauelements sein. Letzteres vereinfacht wiederum den Aufbau- und Verbindungsprozeß erheblich, da ein Standardgehäuse verwendet werden kann, das einen metallisierten Gehäuseboden besitzt.

Da eine einzige, flächige statische Gegenelektrode verwendet wird und eine Mehrzahl von Elektroden zur Erzielung einer Auslenkung oder zur Erfassung einer Auslenkung des bewegbaren Baugliedes in diesem integriert sind, kann eine Justage oder eine laterale Ausrichtung der Elektroden zueinander während des Herstellungsprozesses vollständig entfallen.

Die Herstellung des Bauelements erfolgt mit bekannten Verfahren der Oberflächenmikromechanik und der Volumenmikromechanik. Durch Schleifen des Substrats oder durch Verwenden eines Abstandshalters auf einer Vorder- oder Rückseite des Chips, der das bewegbare Bauglied und die elastischen Verbindungselemente umfaßt ist es möglich, den Abstand zwischen einander gegenüberliegenden Elektroden, beispielsweise zwischen der ersten Elektrode und der dritten Elektrode oder zwischen der zweiten Elektrode und der dritten Elektrode, in einem weiten Bereich zu variieren und somit das mikromechanische Bauelement hinsichtlich der speziellen Aufgabe zu optimieren.

Bevorzugte Ausführungsbeispiele der vorliegenden Erfindung werden nachfolgend Bezug nehmend auf die beiliegenden Figuren näher erläutert. Es zeigen:
- Fig. 1: eine schematische perspektivische Darstellung eines Ausführungsbeispieles eines mikromechanischen Bauelementes gemäß der vorliegenden Erfindung;
- Fig. 2: eine schematische perspektivische Darstellung eines weiteren Ausführungsbeispieles eines mikromechanischen Bauelements gemäß der vorliegenden Erfindung;
- Fig. 3: eine schematische perspektivische Darstellung eines mikromechanischen Bauelements;
- Fig. 4: eine schematische perspektivische Darstellung eines weiteren Ausführungsbeispieles eines mikromechanischen Bauelements gemäß der vorliegenden Erfindung; und
- Fig. 5: eine schematische perspektivische Darstellung eines mikromechanischen Bauelementes gemäß dem Stand der Technik.

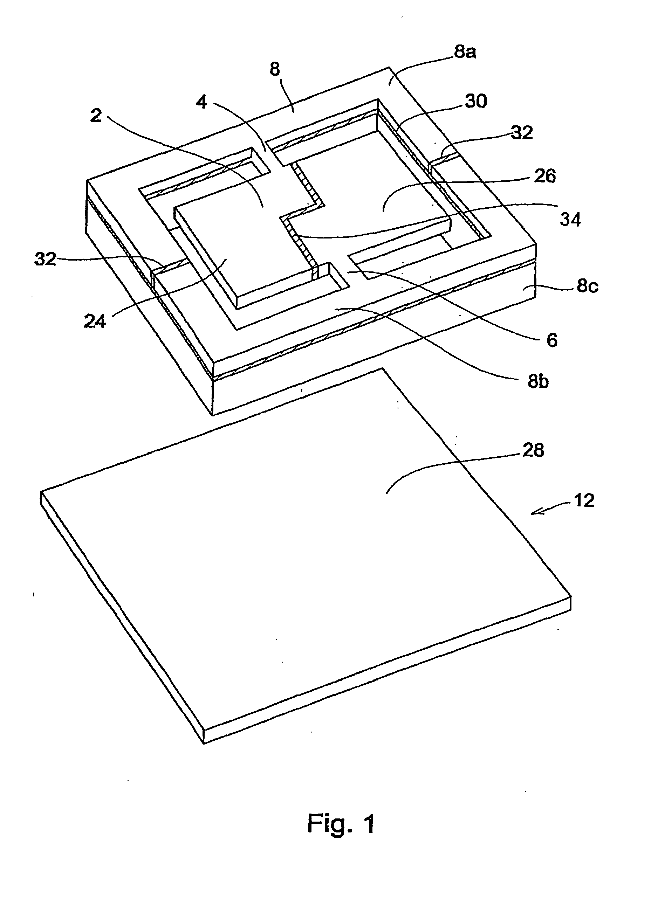

Die Fig. 1 bis 5 sind nicht maßstäbliche schematische Prinzipdarstellungen, in denen eine Grundplatte, welche die Gegenelektrode aufweist, zur besseren Verständlichkeit gegenüber den anderen Komponenten des mikromechanischen Bauelements abgesenkt bzw. von ihnen beabstandet dargestellt ist. Die Figuren können somit als Momentanaufnahmen in einem Fertigungsprozeß eines hybrid aufgebauten mikromechanischen Bauelements verstanden werden. Obwohl das mikromechanische Bauelement gemäß der vorliegenden Erfindung gerade im Fall eines hybriden Aufbaus den oben erläuterten Vorteil aufweist, keine laterale Justage der Elektroden zu erfordern, kann das mikromechanische Bauelement gemäß der vorliegenden Erfindung aber auch einen integrierten Aufbau aufweisen, der immerhin den oben dargestellten Vorteil der einfachen Kontaktierung der Elektroden aufweist.

Fig. 1 zeigt eine schematische perspektivische Darstellung eines Torsionsaktors gemäß der vorliegenden Erfindung. Ein bewegbares Bauglied 2 ist im wesentlichen plattenförmig und weist einen rechteckigen Grundriß auf. In den Mitten der beiden längeren Seiten des bewegbaren Baugliedes 2 ist es mit jeweils einem Ende eines ersten torsionselastischen Verbindungselementes 4 und eines zweiten torsionselastischen Verbindungselementes 6 verbunden. Von dem bewegbaren Bauglied 2 abgewandte Enden der Verbindungselemente 4, 6 sind mit einem Rahmen 8 verbunden, der das bewegbare Bauglied 2 in lateraler Richtung umschließt und von diesem beabstandet ist. Das bewegbare Bauglied 2, die Verbindungselemente 4, 6 und der Rahmen 8 sind einstückig ausgeführt. Der Rahmen 8 weist drei Bereiche 8a, 8b und 8c auf, die voneinander elektrisch isoliert sind. Das bewegbare Bauglied 2 weist zwei voneinander elektrisch isolierte Bereiche auf, welche eine erste Elektrode 24 und eine zweite Elektrode 26 bilden. Die erste Elektrode 24 ist mit dem ersten Verbindungselement 4 und dem ersten Bereich 8a des Rahmens 8 elektrisch leitfähig verbunden. Die zweite Elektrode 26 ist mit dem zweiten Verbindungselement 6 und dem zweiten Bereich 8b des Rahmens 8 elektrisch leitfähig verbunden. Im wesentlichen parallel zu dem bewegbaren Bauglied 2, von diesem beabstandet und elektrisch isoliert ist eine leitfähige Platte 12 angeordnet, welche eine dritte Elektrode 28 bildet.

Das bewegbare Bauglied 2, die Verbindungselemente 4, 6 und der Rahmen 8 werden mit herkömmlichen Verfahrensschritten der Halbleitertechnologie aus einem hochdotierten Siliziumwafer mit einer vergrabenen Isolationsschicht 30 hergestellt. Die vergrabene Isolationsschicht 30 isoliert im fertigen mikromechanischen Bauelement den dritten Bereich 8c des Rahmens 8 von dem ersten Bereich 8a und dem zweiten Bereich 8b. Der Rahmen 8 kann deshalb mit seinem dritten Bereich 8c direkt an der elektrisch leitfähigen Platte 12 angebracht werden ohne die erste Elektrode 24 oder die zweite Elektrode 26 mit der dritten Elektrode 28 kurzzuschließen. In die über der vergrabenen Isolationsschicht 30 liegende hochdotierte Siliziumschicht, aus der das bewegbare Bauglied 2, die Verbindungselemente 4, 6 und der erste und der zweite Bereich 8a, 8b des Rahmens 8 hervorgehen, werden während des Herstellungsverfahrens Gräben 32, 34 geätzt, welche von der von der vergrabenen Isolationsschicht 30 abgewandten Seite dieser Siliziumschicht bis zu der vergrabenen Isolationsschicht 30 reichen. Der Graben 34 im Bereich des späteren bewegbaren Baugliedes 2 wird anschließend mit einem elektrisch isolierenden Material gefüllt. Dies geschieht vorzugsweise bevor unter dem späteren bewegbaren Bauglied 2 liegende Schichten entfernt werden.

Die Gräben 32 isolieren den ersten Bereich 8a und den zweiten Bereich 8b bzw. die erste Elektrode 24 und die zweite Elektrode 26 voneinander, wobei die Gräben 32 im Bereich des Rahmens 8 nicht mit einem elektrisch isolierenden Material gefüllt sein müssen. Der gefüllte Graben 34 im Bereich des bewegbaren Baugliedes 2 stellt gleichzeitig eine starre mechanische Verbindung zwischen der ersten Elektrode 24 und der zweiten Elektrode 26 her.

Die vergrabene Isolationsschicht 30 dient während des Herstellungsverfahrens gleichzeitig als Ätzstopp, so daß ihr Abstand zu der später von der elektrisch leitfähigen Platte 12 beabstandeten Oberfläche des Siliziumwafers gleichzeitig die Dicke des bewegbaren Baugliedes 2 und der Verbindungselemente 4, 6 definiert.

Da die die dritte Elektrode 28 bildende elektrisch leitfähige Platte 12 keine laterale Struktur aufweist, ist eine Ausrichtung oder Justage der elektrisch leitfähigen Platte 12 gegenüber dem bewegbaren Bauglied 2 bzw. der ersten Elektrode 24 und der zweiten Elektrode 26 während der Herstellung nicht erforderlich. An dem fertigen mikromechanischen Bauelement sind ferner nicht dargestellte Kontakte an den Oberflächen des ersten Bereiches 8a und des zweiten Bereiches 8b des Rahmens 8 sowie an der elektrisch leitfähigen Platte 12 vorgesehen. Diese Kontakte werden vorzugsweise mittels Drahtbondtechnik mit zwei Spannungsquellen verbunden, so daß zwei beliebige Spannungen zwischen der ersten Elektrode 24 und der dritten Elektrode 28 bzw. zwischen der zweiten Elektrode 26 und der dritten Elektrode 28 angelegt werden können. Die dritte Elektrode kann alternativ implizit durch eine Verbindung im Gehäuse kontaktiert bzw. mit den Spannungsquellen verbunden werden. Eine Spannung zwischen der ersten Elektrode 24 und der dritten Elektrode 28 hat eine Kraft zur Folge, welche die erste Elektrode 24 zu der dritten Elektrode 28 zieht. Eine Spannung zwischen der zweiten Elektrode 26 und der dritten Elektrode 28 hat eine Kraft zur Folge, welche die zweite Elektrode 26 zu der dritten Elektrode 28 zieht. Je nach dem, ob zwischen der ersten Elektrode 24 und der dritten Elektrode 28 oder zwischen der zweiten Elektrode 26 und der dritten Elektrode 28 eine höhere Spannung angelegt wird und abhängig von der Höhe der Spannung bzw. von der Höhe einer Differenz zweier angelegter Spannungen, kippt das bewegbare Bauglied 2 in der in Fig. 1 gezeigten Darstellung nach links oder rechts. Diese Verkippung bleibt bestehen, so lange die elektrische Spannung anliegt.

Eine mögliche Anwendung des mikromechanischen Bauelementes gemäß dem in Fig. 1 dargestellten Ausführungsbeispiel der vorliegenden Erfindung ist die Reflexion eines Lichtstrahles an dem bewegbaren Bauglied 2, wobei die Richtung, in die der Lichtstrahl reflektiert wird bzw. der Reflexionswinkel durch die Größe der Spannungen zwischen der ersten Elektrode 24 und der dritten Elektrode 28 bzw. zwischen der zweiten Elektrode 26 und der dritten Elektrode 28 abhängt. Damit ist es beispielsweise möglich, einen Lichtstrahl, der an dem bewegbaren Bauglied reflektiert wird, statisch, quasi statisch oder kontinuierlich abzulenken. Zu diesem Zweck wird die von der elektrisch leitfähigen Platte 12 abgewandte Oberfläche des bewegbaren Baugliedes 2 vorzugsweise plan und reflektierend ausgeführt.

Die Anordnung der torsionselastischen Verbindungselemente 4, 6 definiert eine Achse, um die das bewegbare Bauglied 2 rotationsbewegbar ist. Die Darstellung in Fig. 1 zeigt ein bewegbares Bauglied 2, das symmetrisch aufgehängt ist, d. h. der Schwerpunkt des bewegbaren Baugliedes 2 liegt auf der durch die torsionselastischen Verbindungselemente 4, 6 definierten Achse.

Das in Fig. 1 dargestellte Ausführungsbeispiel eines mikromechanischen Bauelements gemäß der vorliegenden Erfindung ist nicht nur, wie oben dargestellt, als Torsionsaktor verwendbar, sondern auch als Sensor. Wenn das bewegbare Bauglied 2 mittels der torsionselastischen Verbindungselemente 4, 6 nicht symmetrisch aufgehängt wird, sondern der Schwerpunkt des bewegbaren Bauglieds 2 außerhalb der durch die torsionselastischen Verbindungselemente 4, 6 definierten Achse liegt, hat eine Beschleunigung des mikromechanischen Bauelements in einer Richtung senkrecht zu der durch den Schwerpunkt des bewegbaren Baugliedes 2 und die Verbindungselemente 4, 6 definierten Ebene eine Verkippung des bewegbaren Baugliedes 2 zur Folge, bei der sich die Kapazitäten zwischen der ersten Elektrode 24 bzw. der zweiten Elektrode 26 und der dritten Elektrode 28 ändern. Wenn das bewegbare Bauglied 2 in der Darstellung in Fig. 1 nach links kippt, nähert sich die erste Elektrode 24 der dritten Elektrode 28, wodurch sich die Kapazität zwischen der ersten Elektrode 24 und der dritten Elektrode 28 verringert. Gleichzeitig erhöht sich entsprechend die Kapazität zwischen der zweiten Elektrode 26 und der dritten Elektrode 28. Dadurch ist es möglich durch eine Messung der beiden Kapazitäten zwischen der ersten Elektrode 24 bzw. der zweiten Elektrode 26 und der dritten Elektrode 28 die Verkippung bzw. Auslenkung des bewegbaren Baugliedes 2 aus seiner Ruhelage quantitativ zu bestimmen. Ein solches System kann beispielsweise als Beschleunigungssensor eingesetzt werden.

Ein mikromechanisches Bauelement mit einem symmetrisch aufgehängten bewegbaren Bauglied 2 eignet sich entsprechend zur Erfassung einer Winkelbeschleunigung, d. h. einer Änderung einer Rotation um eine Achse, die nicht zu der durch die elastischen Verbindungselemente 4, 6 definierten Achse parallel ist.

Ferner ist es möglich mittels des mikromechanischen Bauelements gemäß der vorliegenden Erfindung eine Kraft oder ein Drehmoment zu messen, welches beispielsweise durch Stößel oder Hebel auf das bewegbare Bauglied 2 übertragen wird oder durch den Druck oder die Strömung eines Fluids auf dasselbe ausgeübt werden.

Elektrostatische Kräfte zwischen der ersten Elektrode 24, der zweiten Elektrode 26 und der dritten Elektrode 28 können ferner dazu verwendet werden, um eine äußere Kraft zu kompensieren oder eine Auslenkung des bewegbaren Baugliedes 2 durch eine äußere Kraft oder Beschleunigung zu verringern.

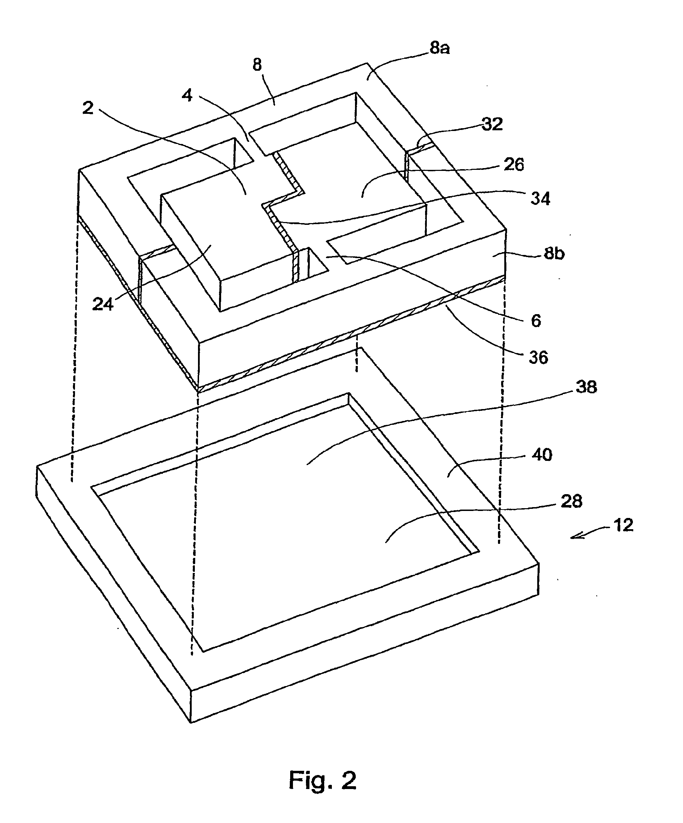

Fig. 2 zeigt ein weiteres Ausführungsbeispiel des mikromechanischen Bauelements gemäß der vorliegenden Erfindung, das ebenfalls ein bewegbares Bauglied 2 aufweist, welches durch einen mit einem isolierenden Material gefüllten Graben 34 in eine erste Elektrode 24 und eine zweite, von der ersten Elektrode 24 durch den gefüllten Graben 34 elektrisch isolierte Elektrode 26 unterteilt. Das bewegbare Bauglied 2 ist wiederum durch ein erstes torsionselastisches Verbindungselement 4 und ein zweites torsionselastisches Verbindungselement 6 an zwei einander gegenüberliegenden Seiten mit einem Rahmen 8 verbunden. Der Rahmen 8 ist durch elektrisch isolierende Gräben 32 in einen ersten Bereich 8a und einen zweiten Bereich 8b unterteilt. Der erste Bereich 8a des Rahmens 8 ist über das erste torsionselastische Verbindungselement 4 mit der ersten Elektrode 24 elektrisch leitfähig verbunden, und der zweite Bereich 8b des Rahmens 8 ist über das zweite torsionselastische Verbindungselement 6 mit der zweiten Elektrode 26 elektrisch leitfähig verbunden. Im Gegensatz zu dem Ausführungsbeispiel aus Fig. 1 weist eine Siliziumschicht, aus der das bewegbare Bauglied, die torsionselastischen Verbindungselemente 4, 6 und der Rahmen 8 gefertigt sind, keine vergrabene Isolationsschicht auf. Zur elektrischen Isolation des ersten Bereiches 8a und des zweiten Bereiches 8b des Rahmens 8 und mit diesen auch der ersten Elektrode 24 und der zweiten Elektrode 26 gegenüber einer elektrisch leitfähigen Platte 12, welche die dritte Elektrode 28 bildet, ist zwischen der elektrisch leitfähigen Platte 12 und dem Rahmen 8 eine elektrisch isolierende Schicht 36 vorgesehen, so daß die erste Elektrode 24, die zweite Elektrode 26 und die dritte Elektrode 28 voneinander vollständig elektrisch isoliert sind.

In diesem Ausführungsbeispiel weisen das bewegbare Bauglied 2 und der Rahmen 8 die gleiche Dicke auf. Die elektrisch leitfähige Platte 12 ist mit einer Vertiefung 38 versehen, die dem bewegbaren Bauglied 2 gegenüber liegt und seine Auslenkung aus der Ruhelage zuläßt. Anders ausgedrückt bildet in diesem Ausführungsbeispiel ein die Vertiefung 38 umschließender erhabener Rand 40 einen Abstandshalter, der im wesentlichen einen Abstand zwischen dem bewegbaren Bauglied 2 und der durch die Vertiefung 38 der elektrisch leitfähigen Platte 12 gebildeten dritten Elektrode 28 erzeugt. Die Ausrichtung bzw. Justage der elektrisch leitfähigen Platte 12 bzw. der Vertiefung 38 darin mit dem bewegbaren Bauglied 2 ist relativ unkritisch und kann beispielsweise durch einfache mechanische Anschläge erfolgen, wenn der Rahmen 8 und die Vertiefung 38 groß genug ausgeführt sind.

Der Rahmen 8 bzw. die isolierende Schicht 36 einerseits und der erhabene Rand 40 der elektrisch leitfähigen Platte 12 andererseits können beispielsweise durch eine Klebung miteinander verbunden werden. Elektrische Kontaktierung und mögliche Verwendungen als Aktor oder Sensor sind mit denen des in Fig. 1 dargestellten Ausführungsbeispieles identisch.

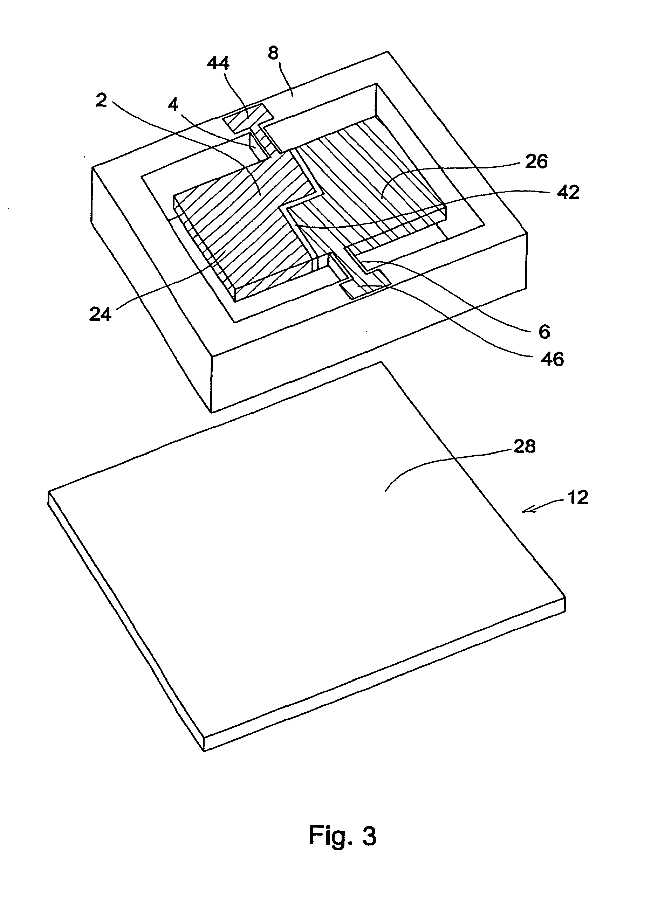

Fig. 3 zeigt ein mikromechanisches Bauelement, dessen Grundgeometrie dem Ausführungsbeispiel aus Fig. 1 entspricht, bei dem jedoch das bewegbare Bauglied 2, die torsionselastischen Verbindungselemente 4, 6 und der Rahmen 8 ein elektrisch isolierendes Material, beispielsweise undotiertes Silizium aufweisen. Die erste Elektrode 24 und die zweite Elektrode 26 sind durch Metallisierungen auf Oberflächen des bewegbaren Baugliedes gebildet, die voneinander durch eine Lücke 42 elektrisch isoliert sind. Die die erste Elektrode 24 bildende Metallisierung erstreckt sich dabei im wesentlichen ausgehend von der durch die torsionselastischen Verbindungselemente 4, 6 gebildeten Achse bis zu einer von dieser Achse entfernten Kante des bewegbaren Baugliedes 2. Die die zweite Elektrode 26 bildende Metallisierung erstreckt sich im wesentlichen von der Achse bis zu einer weiteren, von der Achse beabstandeten Kante des bewegbaren Baugliedes 2. Die erste Elektrode 24 und die zweite Elektrode 26 weisen somit laterale Ausdehnungen auf, die denen aus dem in Fig. 1 dargestellten Ausführungsbeispiel entsprechen, werden jedoch nicht durch das Material des bewegbaren Baugliedes 2 selbst sondern durch Metallisierungen auf dessen Oberflächen gebildet. Die die erste Elektrode 24 bildende Metallisierung erstreckt sich ferner über das erste torsionselastische Verbindungselement 4 bis zum Rahmen 8, auf dessen Oberfläche sie eine erste Kontaktstelle 44 bildet. Die die zweite Elektrode 26 bildende Metallisierung erstreckt sich ferner über eine Oberfläche des zweiten torsionselastischen Verbindungselementes 6 bis zum Rahmen 8, auf dessen Oberfläche sie eine zweite Kontaktstelle 46 bildet. Zur Kontaktierung der ersten Elektrode 24 und der zweiten Elektrode 26 werden beispielsweise mittels Drahtbondtechnik elektrisch leitfähige Verbindung zu den Kontaktstellen 44, 46 hergestellt.

Bei dem in Fig. 3 dargestellten Bauelement weist das bewegbare Bauglied 2 eine geringere Dicke auf als der Rahmen 8, was beispielsweise bei bekannter Ätzrate durch ein Ätzen auf Zeit von der Rückseite her realisiert werden kann.

Da der Rahmen 8 ein isolierendes Material aufweist, kann er direkt, beispielsweise durch Kleben oder Bonden, mit der die dritte Elektrode 28 bildenden elektrisch leitfähigen Platte 12 verbunden werden.

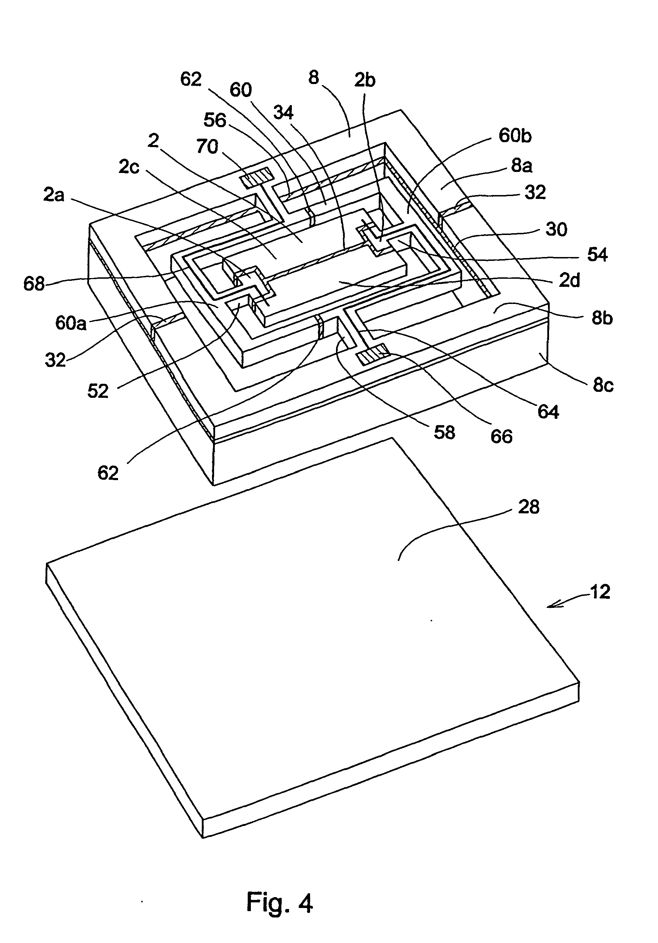

Fig. 4 ist eine schematische perspektivische Darstellung eines weiteren Ausführungsbeispieles des mikromechanischen Bauelements gemäß der vorliegenden Erfindung. Ein bewegbares Bauglied 2 ist hier über vier torsionselastische Verbindungselemente 52, 54, 56, 58 und einen Zwischenrahmen 60 mit einem Rahmen 8 verbunden. Der bewegbare Zwischenrahmen 60 umschließt das bewegbare Bauglied lateral vollständig und wird seinerseits von dem Rahmen 8 lateral vollständig umschlossen. Das bewegbare Bauglied 2 hat die Form einer rechteckigen Platte und ist an zwei einander gegenüberliegenden Seiten jeweils mittig über ein erstes torsionselastisches Verbindungselement 52 und ein zweites torsionselastisches Verbindungselement 54 mit zwei gegenüberliegenden Seiten des ebenfalls rechteckförmigen bewegbaren Zwischenrahmens 60 verbunden. Die anderen beiden, einander gegenüberliegenden Seiten des bewegbaren Zwischenrahmens 60 sind jeweils mittig durch ein drittes torsionselastisches Verbindungselement 56 und ein viertes torsionselastisches Verbindungselement 58 mit einander gegenüberliegenden Seiten des Rahmens 8 verbunden: Es resultiert eine kardanische Aufhängung des bewegbaren Baugliedes 2, wobei das bewegbare Bauglied 2 gegenüber dem bewegbaren Zwischenrahmen 60 und dem Rahmen 8 um eine durch das erste und das zweite torsionselastische Verbindungselement 52, 54 definierte Achse rotierbar ist, und wobei das bewegbare Bauglied 2 und der bewegbare Zwischenrahmen 60 gemeinsam um eine zweite, zu der ersten Achse senkrechten und durch das dritte und das vierte torsionselastische Verbindungselement 56, 58 definierte Achse gegenüber dem Rahmen 8 rotierbar sind.

Das bewegbare Bauglied 2, die Verbindungselemente 52, 54, 56, 58, der bewegbare Zwischenrahmen 60 und der Rahmen 8 sind wie das bewegbare Bauglied 2, die Verbindungselemente 4, 6 und der Rahmen 8 aus dem in Fig. 1 dargestellten Ausführungsbeispiel aus einem dotierten, elektrisch leitfähigen Siliziumwafer mit einer vergrabenen Isolationsschicht gefertigt. Der Rahmen 8 weist elektrisch isolierende Gräben 32 auf, welche ihn zusammen mit der vergrabenen Isolationsschicht 30 in einen ersten Bereich 8a, einen zweiten Bereich 8b und einen dritten Bereich 8c unterteilen, die voneinander elektrisch isoliert sind. Der erste Bereich 8a des Rahmens 8 grenzt an das dritte torsionselastische Verbindungselement 56, und der zweite Bereich 8b des Rahmens 8 grenzt an das vierte torsionselastische Verbindungselement 58. Der bewegbare Zwischenrahmen 60 ist durch mit einem isolierenden Material gefüllte Gräben 62 in einen ersten Bereich 60a, der an das erste und an das dritte torsionselastische Verbindungselement angrenzt, und einen zweiten Bereich 60b, der an das zweite und das vierte Verbindungselemente 54, 58 angrenzt, unterteilt, wobei der erste Bereich 60a und der zweite Bereich 60b des bewegbaren Zwischenrahmens durch die mit einem isolierenden Material gefüllten Gräben 62 mechanisch starr miteinander verbunden und elektrisch voneinander isoliert sind. Die Gräben 62 sind dabei vorzugsweise nahe dem ersten Verbindungselement 56 bzw. dem zweiten Verbindungselement 58 angeordnet. Das bewegbare Bauglied 2 ist durch einen mit einem isolierenden Material gefüllten, an beiden Enden jeweils einfach verzweigten Graben 34 in vier Bereiche 2a, 2b, 2c, 2d unterteilt, welche durch den mit einem isolierenden Material gefüllten Graben 34 mechanisch starr miteinander verbunden und elektrisch voneinander isoliert sind.

Der dritte Bereich 8c des Rahmens 8 wird beispielsweise durch eine Klebung mit einer elektrisch leitfähigen Platte 12 verbunden.

Der erste Bereich 2a des bewegbaren Baugliedes 2 grenzt an das erste torsionselastische Verbindungselement 52 und ist über dieses, den ersten Bereich 60a des bewegbaren Zwischenrahmens 60 und das dritte torsionselastische Verbindungselement 56 mit dem ersten Bereich 8a des Rahmens 8 elektrisch leitfähig verbunden. Der zweite Bereich 2b des bewegbaren Baugliedes 2 grenzt an das zweite torsionselastische Verbindungselement 54 und ist über dieses, den zweiten Bereich 60b des bewegbaren Zwischenrahmens 60 und das vierte torsionselastische Verbindungselement 58 mit dem zweiten Bereich 8b des Rahmens 8 elektrisch leitfähig verbunden. Der dritte Bereich 2c des bewegbaren Baugliedes 2 ist über eine erste Leiterbahn 64, welche über das zweite Verbindungselement 54, den zweiten Bereich 60b des bewegbaren Zwischenrahmens 60 und das vierte Verbindungselement 58 verläuft, und von diesen durch eine nicht dargestellte Isolationsschicht elektrisch isoliert ist, elektrisch leitfähig mit einer ersten Kontaktstelle 66 verbunden, welche auf dem zweiten Bereich 8b des Rahmens 8 angeordnet und von diesem durch eine nicht dargestellte Isolationsschicht elektrisch isoliert ist. Ein vierter Bereich 2d des bewegbaren Baugliedes 2 ist durch eine zweite Leiterbahn 68, welche über das erste Verbindungselement 52, den ersten Bereich 60a des bewegbaren Zwischenrahmens 60 und das dritte Verbindungselement 56 verläuft und von diesen durch eine nicht dargestellte Isolationsschicht elektrisch isoliert ist, elektrisch leitfähig mit einer zweiten Kontaktstelle 70 verbunden, welche auf dem ersten Bereich 8a des Rahmens 8 angeordnet und von diesem durch eine nicht dargestellte Isolationsschicht elektrisch isoliert ist.

Eine erste Elektrode wird durch den ersten Bereich 2a des bewegbaren Baugliedes, das erste Verbindungselement 52 und den ersten Bereich 60a des bewegbaren Zwischenrahmens 60 gebildet und ist über das dritte Verbindungselement 56 mit dem ersten Bereich 8a des Rahmens 8 elektrisch leitfähig verbunden, sie kann deshalb über eine nicht dargestellte weitere Kontaktstelle an dem ersten Bereich 8a des Rahmens 8 kontaktiert werden. Eine zweite Elektrode wird durch den zweiten Bereich 2b des bewegbaren Baugliedes 2, das zweite Verbindungselement 54 und den zweiten Bereich 60b des bewegbaren Zwischenrahmens 60 gebildet und ist über das vierte Verbindungselement 58 elektrisch leitfähig mit dem zweiten Bereich 8b des Rahmens 8 verbunden, sie kann deshalb über eine weitere, nicht dargestellte Kontaktstelle am zweiten Bereich 8b des Rahmens 8 kontaktiert werden. Eine dritte Elektrode 28 wird durch die elektrisch leitfähige Platte 12 gebildet. Eine vierte Elektrode wird durch den dritten Bereich 2c des bewegbaren Baugliedes 2 gebildet und kann über die erste Kontaktstelle 66 kontaktiert werden. Eine fünfte Elektrode wird durch den vierten Bereich 2d des bewegbaren Baugliedes 2 gebildet und kann über die zweite Kontaktstelle 70 kontaktiert werden.

Die Dicke des bewegbaren Baugliedes 2, der Verbindungselemente 52, 54, 56, 58 und des Zwischenrahmens 60 wird wie in dem in Fig. 1 dargestellten Ausführungsbeispiel durch die Anordnung einer vergrabenen Isolationsschicht 30 innerhalb des verwendeten Siliziumwafers definiert, da die vergrabene Isolationsschicht 30 in diesem Ausführungsbeispiel als Ätzstopp dient. Wenn eine Spannung zwischen der ersten, durch den ersten Bereich 2a des bewegbaren Baugliedes 2, das erste Verbindungselement 52 und den ersten Bereich 60a des bewegbaren Zwischenrahmens 60 gebildete Elektrode und die dritte Elektrode 28 angelegt wird, erfährt die erste Elektrode eine anziehende Kraft zu der dritten Elektrode 28 hin, und, da die erste Elektrode bezogen auf die in Fig. 4 dargestellte Darstellung im wesentlichen links von der durch das dritte und das vierte Verbindungselement 56, 58 definierten Achse liegt, kippt das bewegbare Bauglied 2 um diese Achse nach links. Entsprechend kippt das bewegbare Bauglied 2 nach rechts, wenn eine Spannung zwischen der zweiten Elektrode, die durch den zweiten Bereich 2b des bewegbaren Baugliedes 2, das zweite Verbindungselement 54 und den zweiten Bereich 60b des bewegbaren Zwischenrahmens 60 gebildet wird, und der dritten Elektrode 28 angelegt wird. Wenn zwischen der durch den dritten Bereich 2c des bewegbaren Baugliedes 2 gebildeten vierten Elektrode und der dritten Elektrode 28 eine Spannung angelegt wird, kippt das bewegbare Bauglied 2 um die durch das erste und das zweite torsionselastische Verbindungselement 52, 54 definierte Achse nach hinten, wenn eine Spannung zwischen der durch den vierten Bereich 2d des bewegbaren Baugliedes 2 gebildete fünfte Elektrode und der dritten Elektrode 28 angelegt wird, kippt das bewegbare Bauglied 2 um die gleiche Achse nach vorne, da die vierte Elektrode bezogen auf die in Fig. 4 gezeigte Darstellung im wesentlichen hinter dieser Achse und die fünfte Elektrode im wesentlichen vor dieser Achse angeordnet ist.

Das in Fig. 4 dargestellte Ausführungsbeispiel eines mikromechanischen Bauelements gemäß der vorliegenden Erfindung ist somit dazu geeignet, gesteuert durch vier elektrische Spannungen Rotationsbewegungen um zwei zueinander senkrechte Achsen auszuführen. Dies kann beispielsweise zur zweidimensionalen Ablenkung eines Lichtstrahles verwendet werden. In diesem Fall ist die von der dritten Elektrode 28 abgewandte Oberfläche des bewegbaren Baugliedes 2 vorzugsweise plan und reflektierend ausgeführt. Ferner ist das in Fig. 4 gezeigte Ausführungsbeispiel eines mikromechanischen Bauelements gemäß der vorliegenden Erfindung analog den in Zusammenhang mit dem in Fig. 1 gezeigten Ausführungsbeispiel gemachten Ausführungen als Sensor für Kräfte, Beschleunigungen oder Winkelbeschleunigung in zwei zueinander senkrechten Richtungen geeignet.

Wenn das bewegbare Bauglied 2, wie es in Fig. 4 dargestellt ist, symmetrisch aufgehängt ist, d. h. der Schwerpunkt des bewegbaren Baugliedes 2 auf der durch das erste Verbindungselement 52 und das zweite Verbindungselement 54 definierten Achse liegt und der Schwerpunkt des bewegbaren Baugliedes 2 zusammen mit dem ersten Verbindungselement 52, dem zweiten Verbindungselement 54 und dem bewegbaren Zwischenrahmen 60 auf der durch das dritte Verbindungselement 56 und das vierte Verbindungselement 58 definierten Achse liegt, eignet sich das mikromechanische Bauelement für eine Erfassung der Komponenten einer Winkelbeschleunigung parallel zu den beiden durch die Verbindungselemente 52, 54, 56, 58 definierten Achsen.

Abweichend von den anhand der Fig. 1 bis 4 dargestellten Ausführungsbeispielen des mikromechanischen Bauelements gemäß der vorliegenden Erfindung sind zahlreiche Modifikationen möglich. Beispielsweise können das bewegbare Bauglied 2, die Verbindungselemente 4, 6; 52, 54, 56, 58, der Rahmen 8 und gegebenenfalls der bewegbare Zwischenrahmen 60 einstückig oder mehrstückig ausgeführt sein und das gleiche oder voneinander verschiedene Materialien aufweisen. Als Materialien kommen neben dem beschriebenen Silizium auch andere Halbleitermaterialien oder Metalle in Frage.

Ferner können Merkmale verschiedener Ausführungsbeispiele miteinander kombiniert werden.

Ferner kann die dritte Elektrode 28 abweichend von den gezeigten Ausführungsbeispielen nicht nur eine plane, sondern alternativ auch eine strukturierte Oberfläche aufweisen und/oder mit einer ebenen oder strukturierten isolierenden Schicht, isolierenden Anschlägen, einem isolierenden Rahmen, etc. versehen sein, um bei einer maximalen Auslenkung des bewegbaren Baugliedes 2 bzw. ggf. des bewegbaren Zwischenrahmens 60 einen Kurzschluß zwischen der ersten, zweiten, vierten oder fünften Elektrode 24, 26 einerseits und der dritten Elektrode 28 andererseits sowie eine Überlastung der torsionselastischen Verbindungselemente 4, 6; 52, 54, 56, 58 zu vermeiden. Gleiches kann durch entsprechende Strukturen aus einem isolierenden Material an dem bewegbaren Bauglied 2 bewirkt werden, beispielsweise durch eine elektrisch isolierende Schicht an der der dritten Elektrode 28 zugewandten Oberfläche des bewegbaren Baugliedes 2.

Anstatt einer Aufhängung des bewegbaren Baugliedes 2 an torsionselastischen Verbindungselementen 4, 6; 52, 54, 56, 58 ist ferner eine analoge Ausführung mit biegeelastischen Verbindungselementen oder eine Kombination von torsionselastischen und biegeelastischen Verbindungselementen möglich. Ferner kann das bewegbare Bauglied 2 nicht nur um eine oder mehrere Achsen kippbar bzw. rotierbar sondern alternativ oder gleichzeitig in eine oder mehrere Richtungen translatierbar bzw. verschiebbar aufgehängt sein.

Das bewegbare Bauglied 2 kann plattenförmig mit zwei planparallelen Oberflächen und rechteckigem Grundriß sein oder aber eine andere für die jeweilige Anwendung geeignete Form aufweisen. Beispielsweise kann es an seiner von der dritten Elektrode 28 abgewandten Oberfläche eine Struktur aufweisen, welche eine Übertragung einer äußeren Kraft auf das bewegbare Bauglied erleichtert oder ermöglicht.

Ferner können das bewegbare Bauglied 2 und die elastischen Verbindungselemente 4, 6; 52, 54, 56, 58 unterschiedliche Dicken aufweisen.

In allen beschriebenen Ausführungsbeispielen stellt der Rahmen 8 nur eine Möglichkeit der mechanisch starren Verbindung der elastischen Verbindungselemente 4, 6, 56, 58 mit dem Substrat dar. Alternativ können Pfosten, Stege oder Inseln oder andere Strukturen auf der Oberfläche des Substrats 12 vorgesehen sein, an denen die elastischen Verbindungselemente 4, 6, 56, 58 angebracht sind. Obgleich es möglich und vorteilhaft ist, den Rahmen 8 gemeinsam und einstückig mit dem bewegbaren Bauglied 2 und den elastischen Verbindungselemente 4, 6, 56, 58 herzustellen und erst in einem späteren Herstellungsschritt mit dem Substrat 12 zu verbinden, kann der Rahmen 8 somit funktionell eher als Bestandteil des Substrats angesehen werden.

Ferner können in der Nähe des bewegbaren Baugliedes eine oder mehrere weitere statische Elektroden angeordnet sein. Beispielsweise ist es im Fall der Verwendung des mikromechanischen Bauelementes als Aktor in einer optischen Anwendung zur gesteuerten Ablenkung eines Lichtstrahles möglich, eine über der von der dritten Elektrode 28 abgewandten Seite des bewegbaren Baugliedes 2 angeordnete, zum Schutz des mikromechanischen Bauelements vorgesehene transparente Platte mit einer transparenten leitfähigen Beschichtung zu versehen und zwischen dieser und der dritten Elektrode 28 eine Spannung anzulegen, so daß abhängig von der Wahl des Potentials der ersten Elektrode 24 und der zweiten Elektrode 26 diese nicht nur von der dritten Elektrode 28 sondern auch von der leitfähigen Beschichtung der transparenten Platte angezogen werden können, wodurch bei vergleichbaren Spannungen eine stärkere Auslenkung des bewegbaren Baugliedes 2 möglich ist.

Wenn zwei statische Elektroden vorgesehen sind, wie im zuletzt beschriebenen Beispiel die dritte Elektrode 28 und die transparente leitfähige Beschichtung, können diese bezogen auf das bewegbare Bauglied 2 symmetrisch angeordnet sein. Durch eine symmetrische Anordnung der statischen Elektroden bezogen auf das bewegbare Bauglied 2 und insbesondere bezogen auf die erste Elektrode 24, die zweite Elektrode 26 und ggf. weitere Elektroden, die das bewegbare Bauglied aufweist, ist eine Symmetrisierung der angreifenden elektrostatischen Kräfte erreichbar, so daß bei einer erwünschten Rotationsbewegung eine parasitäre Translationsbewegung, die bei Verwendung nur einer statischen Elektrode bzw. Gegenelektrode (auf einer Seite des bewegbaren Baugliedes 2) auftritt, unterdrückt bzw. stark verringert wird. Dies ist für viele Anwendungen ein wesentlicher Vorteil.

## Patentansprüche

1. Mikromechanisches Bauelement mit folgenden Merkmalen:
einem Substrat (12); und
einem Bauglied (2), das bewegbar an dem Substrat (12) angebracht ist,
wobei das bewegbare Bauglied (2) in einer elektrisch leitfähigen Schicht gebildet ist, wobei ein erster Bereich des bewegbaren Bauglieds (2) eine erste Elektrode (24) bildet, ein zweiter Bereich des bewegbaren Bauglieds (2) eine zweite Elektrode (26) bildet, und die erste Elektrode (24) und die zweite Elektrode (26) durch einen elektrisch isolierenden dritten Bereich (34, 42), der die leitfähige Schicht durchdringt, von einander elektrisch isoliert sind, und
wobei das Substrat (12) eine dritte Elektrode (28) aufweist, die der ersten Elektrode (24) und der zweiten Elektrode (26) zumindest teilweise gegenüber liegt.

2. Mikromechanisches Bauelement nach Anspruch 1, bei dem das bewegbare Bauglied (2) plattenförmig ist und eine erste Oberfläche und eine zweite Oberfläche aufweist,
wobei die erste Elektrode (24) und die zweite Elektrode (26) jeweils mindestens eine Teilfläche der ersten Oberfläche oder eine Teilfläche der zweiten Oberfläche einnehmen.

3. Mikromechanisches Bauelement nach Anspruch 1 oder 2, ferner mit:
einem ersten und einem zweiten torsionselastischen Verbindungselement (4, 6), über die das bewegbare Bauglied (2) an dem Substrat (12) angebracht ist.

4. Mikromechanisches Bauelement nach Anspruch 1 oder 2, ferner mit:
einem Rahmen (60);
einem ersten und einem zweiten torsionselastischen Verbindungselement (52, 54), über die das bewegbare Bauglied (2) an zwei gegenüberliegenden Seiten um eine erste Achse drehbewegbar mit dem Rahmen (60) verbunden ist; und
einem dritten und einem vierten torsionselastischen Verbindungselement (56, 58), über die der Rahmen (60) an zwei gegenüberliegenden Seiten um eine zweite Achse drehbewegbar mit dem Substrat (12) verbunden ist,
wobei die erste Achse und die zweite Achse im wesentlichen senkrecht zueinander sind, und
wobei das bewegbare Bauglied (2) ferner eine vierte Elektrode und eine fünfte Elektrode aufweist.

5. Mikromechanisches Bauelement nach einem der Ansprüche 1 bis 3, ferner mit:
einem ersten und einem zweiten biegeelastischen Verbindungselement, über die das bewegbare Bauglied an dem Substrat angebracht ist.

6. Mikromechanisches Bauelement nach Anspruch 3, 4 oder 5, bei dem die Verbindungselemente (4, 6; 52, 54, 56, 58) und das bewegbare Bauglied (2) das gleiche Material aufweisen.

7. Mikromechanisches Bauelement nach einem der Ansprüche 3 bis 6, bei dem das erste Verbindungselement (4, 52) die erste Elektrode (24) elektrisch leitfähig mit einem ersten elektrischen Leiter (8a) verbindet, und das zweite Verbindungselement (6, 52) die zweite Elektrode (26) elektrisch leitfähig mit einem zweiten elektrischen Leiter (8b) verbindet.

8. Mikromechanisches Bauelement nach einem der Ansprüche 1 bis 7, bei dem das elektrisch leitfähige Material des bewegbaren Baugliedes (2) ein dotiertes Halbleitermaterial ist und der elektrisch isolierende dritte Bereich (34) ein undotiertes Halbleitermaterial oder einen durch ein elektrisch isolierendes Material aufgefüllten Graben aufweist.

9. Mikromechanisches Bauelement nach einem der Ansprüche 1 bis 8, bei dem das Substrat (12) ein elektrisch leitfähiges Material aufweist.

10. Mikromechanisches Bauelement nach einem der Ansprüche 1 bis 8, bei dem das Substrat (12) ein elektrisch isolierendes Material aufweist, wobei die dritte Elektrode (28) eine Metallisierung einer dem bewegbaren Bauglied (2) gegenüberliegenden Oberfläche des Substrats (2) aufweist.

11. Mikromechanisches Bauelement nach einem der Ansprüche 1 bis 8, bei dem das Substrat (12) ein Halbleitermaterial aufweist, wobei die dritte Elektrode (28) einen dotierten Bereich des Substrats (12) umfaßt.

12. Mikromechanisches Bauelement nach einem der Ansprüche 1 bis 8, bei dem ein elektrisch leitfähiger Abschnitt eines Gehäuses das Substrat und die dritte Elektrode (28) bildet.

13. Mikromechanisches Bauelement nach einem der Ansprüche 1 bis 12, ferner mit einer weiteren Elektrode, die in Bezug auf das Substrat (12) unbewegbar angeordnet ist, und die bezogen auf das bewegbare Bauglied (2) symmetrisch zu der dritten Elektrode (28) angeordnet ist.

14. Mikromechanisches Bauelement aus einem linearen oder zweidimensionalen Array von mikromechanischen Bauelementen nach einem der Ansprüche 1 bis 13.

15. Sensor mit einem mikromechanischen Bauelement nach einem der Ansprüche 1 bis 13, bei dem das bewegbare Bauglied (2) dafür vorgesehen ist, durch eine äußere Kraft, Beschleunigung oder Winkelbeschleunigung ausgelenkt zu werden, wobei eine erste Kapazität zwischen der ersten Elektrode (24) und der dritten Elektrode (28) und eine zweite Kapazität zwischen der zweiten Elektrode (26) und der dritten Elektrode (28) von einem Auslenkungszustand des bewegbaren Baugliedes abhängen.

16. Aktor mit einem mikromechanischen Bauelement nach einem der Ansprüche 1 bis 13, bei dem das bewegbare Bauglied (2) dafür vorgesehen ist, daß zwischen der ersten Elektrode (24) und der dritten Elektrode (28) eine erste Spannung und zwischen der zweiten Elektrode (26) und der dritten Elektrode (28) eine zweite Spannung angelegt werden, wobei ein Auslenkungszustand des Baugliedes (2) von der ersten Spannung und der zweiten Spannung abhängt.

17. Aktor zur Ablenkung von Licht, nach Anspruch 16, bei dem das Bauglied eine lichtreflektierende Oberfläche aufweist.

## Claims

1. A micromechanical device, comprising:
a substrate (12); and
a member (2) which is moveably attached to the substrate (12),
wherein the moveable member (2) is formed in an electrically conductive layer, wherein a first area of the moveable member (2) forms a first electrode (24), a second area of the moveable member (2) forms a second electrode (26), and wherein the first electrode (24) and the second electrode (26) are electrically insulated from each other by an electrically insulating third area (34, 42) which penetrates the conductive layer, and
wherein the substrate (12) comprises a third electrode (28) which is at least partially opposed to the first electrode (24) and the second electrode (26).

2. The micromechanical device according to claim 1,
wherein the moveable member (2) is plate-shaped and comprises a first surface and a second surface,
wherein the first electrode (24) and the second electrode (26) each occupy at least a partial area of the first surface or a partial area of the second surface.

3. The micromechanical device according to claim 1 or 2, further comprising:
a first and a second torsion-elastic connecting element (4, 6) via which the moveable member (2) is attached to the substrate (12).

4. The micromechanical device according to claim 1 or 2, further comprising:
a frame (60);
a first and a second torsion-elastic connecting element (52, 54) via which, at two opposing sides, the moveable member (2) is connected to the frame (60) rotationally moveable around a first axis; and
a third and a fourth torsion-elastic connecting element (56, 58) via which, at two opposing sides, the frame (60) is connected to the substrate (12) rotationally moveable around a second axis,
wherein the first axis and the second axis are basically perpendicular to each other, and
wherein the moveable member (2) further comprises a fourth electrode and a fifth electrode.

5. The micromechanical device according to one of claims 1 to 3, further comprising:
a first and a second bending-elastic connecting element, via which the moveable member is attached to the substrate.

6. The micromechanical device according to claim 3, 4 or 5, wherein the connecting elements (4, 6; 52, 54, 56, 58) and the moveable member (2) comprise the same material.

7. The micromechanical device according to one of claims 3 to 6, wherein the first connecting element (4, 52) connects the first electrode (24) to a first electric conductor (8a) in an electrically conductive manner, and wherein the second connecting element (6, 52) connects the second electrode (26) to a second electric conductor (8b) in an electrically conductive way.

8. The micromechanical device according to one of claims 1 to 7, wherein the electrically conductive material of the moveable member (2) is a doped semiconductor material and the electrically insulating third area (34) comprises an undoped semiconductor material or a trench filled by an electrically insulating material.

9. The micromechanical device according to one of claims 1 to 8, wherein the substrate (12) comprises an electrically conductive material.

10. The micromechanical device according to one of claims 1 to 8, wherein the substrate (12) comprises an electrically insulating material, wherein the third electrode (28) comprises a metallization of a surface of the substrate (2) opposite the moveable member (2).

11. The micromechanical device according to one of claims 1 to 8, wherein the substrate (12) comprises a semiconductor material, wherein the third electrode (28) includes a doped area of the substrate (12).

12. The micromechanical device according to one of claims 1 to 8, wherein an electrically conductive section of a housing forms the substrate and the third electrode (28).

13. The micromechanical device according to one of claims 1 to 12, further comprising a further electrode which is arranged in an immobile way with respect to the substrate (12), and which is arranged symmetrically to the third electrode (28) with respect to the moveable member (2).

14. A micromechanical device from a linear or a two-dimensional array of micromechanical devices according to one of claims 1 to 13.

15. A sensor, comprising a micromechanical device according to one of claims 1 to 13, wherein the moveable member (2) is provided to be deflected by an exterior force, acceleration or angular acceleration, wherein a first capacity between the first electrode (24) and the third electrode (28) and a second capacity between the second electrode (26) and the third electrode (28) depend on a deflection state of the moveable member.

16. An actuator having a micromechanical device according to one of claims 1 to 13, wherein the moveable member (2) is provided so that between the first electrode (24) and the third electrode (28) a first voltage and between the second electrode (26) and the third electrode (28) a second voltage is applied, wherein a deflection state of the member (2) depends on the first voltage and the second voltage.

17. An actuator according to claim 16 for the deflection of light, wherein the member comprises a light-reflecting surface.

## Revendications

1. Composant micromécanique, aux caractéristiques suivantes :
un substrat (12) ; et
un composant (2) qui est placé de manière mobile sur le substrat (12),
le composant mobile (2) étant formé dans une couche électroconductrice, une première zone du composant mobile (2) formant une première électrode (24), une deuxième zone du composant mobile (2) formant une deuxième électrode (26), et la première électrode (24) et la deuxième électrode (26) étant isolées électriquement l'une de l'autre par une troisième zone électriquement isolante (34, 42) qui traverse la couche conductrice, et
le substrat (12) présentant une troisième électrode (28) qui fait face au moins partiellement à la première électrode (24) et à la deuxième électrode (26).

2. Composant micromécanique selon la revendication 1, dans lequel le composant mobile (2) est en forme de plaque et présente une première surface et une deuxième surface, la première électrode (24) et la deuxième électrode (26) occupant, chacune, au moins une surface partielle de la première surface ou une surface partielle de la deuxième surface.

3. Composant micromécanique selon la revendication 1 ou 2, par ailleurs, avec :
un premier et un deuxième élément de connexion élastique en torsion (4, 6) par l'intermédiaire desquels le composant mobile (2) est placé sur le substrat (12).

4. Composant micromécanique selon la revendication 1 ou 2, par ailleurs, avec :
un cadre (60) ;
un premier et un deuxième élément de connexion élastique en torsion (52, 54), par l'intermédiaire desquels le composant mobile (2) est relié au cadre (60), à deux côtés opposés, de manière mobile en rotation autour d'un premier axe ; et
un troisième et un quatrième élément de connexion élastique torsion (56, 58), par l'intermédiaire desquels le cadre (60) est relié au substrat (12), à deux côtés opposés, de manière mobile en rotation autour d'un deuxième axe,
le premier axe et le deuxième axe étant sensiblement perpendiculaires entre eux, et
le composant mobile (2) présentant, par ailleurs une quatrième électrode et une cinquième électrode.

5. Composant micromécanique selon l'une des revendications 1 à 3, par ailleurs, avec :
un premier et un deuxième élément de connexion élastique en flexion par l'intermédiaire desquels le composant mobile est placé sur le substrat.

6. Composant micromécanique selon la revendication 3, 4 ou 5, dans lequel les éléments de connexion (4, 6 ; 52, 54, 56, 58) et le composant mobile (2) présentent le même matériau.

7. Composant micromécanique selon l'une des revendications 3 à 6, dans lequel le premier élément de connexion (4, 52) relie la première électrode (24) de manière électroconductrice à un premier conducteur électrique (8a), et le deuxième élément de connexion (6, 52) relie la deuxième électrode (26) de manière électroconductrice à un deuxième conducteur électrique (8b).

8. Composant micromécanique selon l'une des revendications 1 à 7, dans lequel le matériau électroconducteur du composant mobile (2) est un matériau semi-conducteur dopé et la troisième zone électriquement isolante (34) présente un matériau semi-conducteur non dopé ou un fossé rempli d'un matériau électriquement isolant.

9. Composant micromécanique selon l'une des revendications 1 à 8, dans lequel le substrat (12) présente un matériau électroconducteur.

10. Composant micromécanique selon l'une des revendications 1 à 8, dans lequel le substrat (12) présente un matériau électriquement isolant, la troisième électrode (28) présentant une métallisation d'une surface du substrat (2) faisant face au composant mobile (2).

11. Composant micromécanique selon l'une des revendications 1 à 8, dans lequel le substrat (12) présentant un matériau semi-conducteur, la troisième électrode (28) comprenant une zone dopée du substrat (12).

12. Composant micromécanique selon l'une des revendications 1 à 8, dans lequel un segment électroconducteur d'un boîtier constitue le substrat et la troisième électrode (28).

13. Composant micromécanique selon l'une des revendications 1 à 12, par ailleurs, avec une autre électrode qui est disposée immobile par rapport au substrat (12),
et qui, par rapport au composant mobile (2), est disposée de manière symétrique à la troisième électrode (28).

14. Composant micromécanique composé d'une rangée linéaire ou bidimensionnelle de composants micromécaniques selon l'une des revendications 1 à 13.

15. Capteur avec un composant micromécanique selon l'une des revendications 1 à 13, dans lequel le composant mobile (2) est prévu de manière à être dévié par une force extérieure, une accélération ou une accélération angulaire, une première capacité entre la première capacité (24) et la troisième électrode (28) et une deuxième capacité entre la deuxième électrode (26) et la troisième électrode (28) étant fonction de l'état de déviation du composant mobile.

16. Actionneur avec un composant micromécanique selon l'une des revendications 1 à 13, dans lequel le composant mobile (2) est prévu de manière à appliquer, entre la première électrode (24) et la troisième électrode (28), une première tension et, entre la deuxième électrode (26) et la troisième électrode (28), une deuxième tension, un état de déviation du composant (2) étant fonction de la première tension et de la deuxième tension.

17. Actionneur pour dévier de la lumière, selon la revendication 16, dans lequel le composant présente une surface réfléchissant la lumière.
